(19) Europäisches Patentamt
European Patent Office
Office européen des brevets

(11) Veröffentlichungsnummer: **0 073 413**
**B1**

# (12) EUROPÄISCHE PATENTSCHRIFT

(45) Veröffentlichungstag der Patentschrift: **05.12.84**

(51) Int. Cl.³: **C 07 F 9/53**, C 08 F 2/50, C 08 K 5/53, G 03 C 1/68, G 03 F 1/02

(21) Anmeldenummer: **82107509.0**

(22) Anmeldetag: **18.08.82**

## (54) Acylphosphinoxidverbindungen und ihre Verwendung.

(30) Priorität: **24.08.81 DE 3133419**

(43) Veröffentlichungstag der Anmeldung: **09.03.83 Patentblatt 83/10**

(45) Bekanntmachung des Hinweises auf die Patenterteilung: **05.12.84 Patentblatt 84/49**

(84) Benannte Vertragsstaaten: **BE CH DE FR GB IT LI NL SE**

(56) Entgegenhaltungen:
**EP - A - 0 007 086**
**EP - A - 0 007 508**

(73) Patentinhaber: **BASF Aktiengesellschaft, Carl-Bosch-Strasse 38, D-6700 Ludwigshafen (DE)**

(72) Erfinder: **Henne, Andreas, Dr., Bruesseler Ring 34, D-6700 Ludwigshafen (DE)**
Erfinder: **Hesse, Anton, Dr., Peter-Nickel-Strasse 15, D-6940 Weinheim (DE)**
Erfinder: **Jacobi, Manfred, Dr., Heidelberger Ring 32 B, D-6710 Frankenthal (DE)**
Erfinder: **Schornick, Gunnar, Dr., Konrad-Adenauer-Strasse 8, D-6719 Neuleiningen (DE)**
Erfinder: **Vyvial, Rudolf, Alwin-Mittasch-Platz 11, D-6700 Ludwigshafen (DE)**
Erfinder: **Holoch, Klaus, Dr., Virchowstrasse 4, D-6712 Bobenheim-Roxheim (DE)**

EP 0 073 413 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft neue Acylphosphinoxidverbindungen und ihre Verwendung als Photoinitiatoren in photopolymerisierbaren Massen, wie Überzugsmittel, Lacke, Druckfarben, ungesättigte Polyesterformmassen sowie Aufzeichnungsmaterialien.

Aus den DE-OS Nrn. 2830927, 2909994 sowie den europäischen Patentanmeldungen Nrn. 7086 und 7508 sind bereits Acylphosphinoxidverbindungen und ihre Verwendung als Photoinitiatoren bekannt. Nach DE-OS Nr. 2909994 lassen sich auch pigmentierte Lackfilme mit Hilfe der dort beschriebenen Acyldiphenylphosphinoxidverbindungen mit UV-Licht härten. Für die Härtung von Druckfarben und pigmentierten Lacken besteht jedoch ein Bedarf an Photoinitiatoren, die die Lichthärtung in noch dickeren Schichten erlauben als die in der DE-OS Nr. 2909994 beschriebenen Verbindungen.

Überraschend wurde gefunden, dass sich pigmentierte Lacke und Druckfarben in höheren Schichtdicken mit solchen Acyldiphenylphosphinoxiden härten lassen, die in 2-Stellung der phosphorständigen Phenylringe einen Methyl- oder Ethylsubstituenten tragen. Zusätzliche Substituenten im Phenylkern verändern diese Wirkung nicht.

Gegenstand der vorliegenden Erfindung sind Acylphosphinoxide der allgemeinen Formel (I)

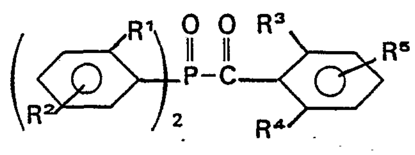
(I)

wobei

$R^1$ für eine Methyl- oder Ethylgruppe,

$R^2$ für eine verzweigte oder unverzweigte Alkylgruppe mit 1 bis 4 Kohlenstoffatomen, ein Chloratom, eine Alkoxygruppe mit 1 bis 4 Kohlenstoffatomen oder ein Wasserstoffatom stehen,

$R^3$ und $R^4$ untereinander gleich oder verschieden sind und für eine Alkyl-, Alkoxy- oder Alkylthiogruppe mit 1 bis 4 Kohlenstoffatomen oder ein Chloratom, und

$R^5$ für ein Wasserstoffatom, ein Chloratom, eine Alkoxy- oder Alkylthiogruppe mit 1 bis 6 Kohlenstoffatomen oder eine verzweigte oder unverzweigte Alkylgruppe mit 1 bis 12 Kohlenstoffatomen stehen.

Gegenstand der vorliegenden Erfindung ist ferner die Verwendung der Acylphosphinoxide der allgemeinen Formel (I) als Photoinitiatoren in photopolymerisierbaren Massen, z.B. für Überzugsmittel, Lacke, Druckfarben sowie zur Herstellung von Kunststofformteilen auf Basis ungesättigter Polyesterharze, wobei diese Acylphosphinoxide gegebenenfalls auch in Kombination mit sekundären oder tertiären Aminen, anderen Photoinitiatoren oder Initiatoren für die thermische Polymerisation eingesetzt werden können.

Bevorzugt ist der durch $R^1$ und $R^2$ substituerte Phenylring ein 2-Methylphenyl- oder ein 2,5-Dimethylphenylring. Bei dem durch $R^3$ bis $R^5$ substituierten Phenylring handelt es sich vorzugsweise um einen 2,6-Dimethylphenyl-, 2,4,6-Trimethylphenyl-, 2,3,6-Trimethylphenyl-, 2,6-Dimethoxyphenyl-, 2,6-Dichlorphenyl-, 2,6-Bis(methylthio)phenyl-, einen 2,6-Dimethyl-4-tert.-butylphenyl- oder einen 2,6-Dimethyl-4-octylphenylrest.

Als Beispiele für die erfindungsgemässen Verbindungen seien genannt:

2,4,6-Trimethylbenzoylbis(o-tolyl)phosphinoxid

2,6-Dimethoxybenzoylbis(o-tolyl)phosphinoxid

2,6-Dichlorbenzoylbis(o-tolyl)phosphinoxid

2,6-Dimethyl-4-tert.-butylbenzoylbis(o-tolyl)-phosphinoxid

2,6-Dimethyl-4-octylbenzoylbis(o-tolyl)phosphinoxid

2,4,6-Trimethylbenzoylbis-(2,5-dimethylphenyl)phosphinoxid

2,6-Dimethoxybenzoylbis-(2,5-dimethylphenyl)phosphinoxid

2,4,6-Trimethylbenzoylbis-(2,3-dimethylphenyl)phosphinoxid

2,6-Dichlorbenzoylbis-(2,5-dimethylphenyl)-phosphinoxid

2,6-Dimethyl-4-tert.-butylbenzoylbis-(2,5-dimethylphenyl)phosphinoxid.

Die Herstellung der erfindungsgemässen Substanzen kann in ähnlicher Weise, wie in DE-OS Nr. 2909994 beschrieben, erfolgen. Die Herstellung der dazu erforderlichen Bis(o-alkylphenyl)-alkoxyphosphine ist beispielsweise in der deutschen Patentanmeldung P Nr. 3102344.4 beschrieben.

Die erfindungsgemässen Acylphosphinoxidverbindungen zeigen eine sehr gute Reaktivität als Photoinitiatoren für photopolymerisierbare Monomere mit mindestens einer C-C-Mehrfachbindung und Mischungen derselben miteinander und mit bekannten Zusatzstoffen. Die erfindungsgemässen Acylphosphinoxidverbindungen eignen sich besonders gut als Photoinitiatoren in photopolymerisierbaren Massen für Überzüge, Lacke, Druckfarben und Aufzeichnungsmaterialien. Sie sind hinsichtlich der Vergilbung der so erhaltenen Lacke bzw. Überzüge bekannten Photoinitiatoren, z.B. dem aus der DE-AS Nr. 2261383 bekannten Benzyldimethylketal, weit überlegen. Bei der Härtung von pigmentierten Schichten lassen sich mit den erfindungsgemässen Verbindungen dickere Lackfilme aushärten als mit den in der DE-OS Nr. 2909994 beschriebenen Acylphosphinoxidverbindungen.

Die erfindungsgemässen Acylphosphinoxidverbindungen sind ausserdem sehr vorteilhaft als Photoinitiatoren für die Lichthärtung von styrolischen Polyesterharzen, die gegebenenfalls Glasfasern und andere Hilfsstoffe enthalten können, verwendbar.

Als photopolymerisierbare Monomere eignen sich die üblichen Verbindungen und Stoffe mit polymerisierbaren C-C-Doppelbindungen, die durch z.B. Aryl-, Carbonyl-, Amino-, Amid-, Amido-,

Ester-, Carboxy- oder Cyanidgruppen, Halogenatome oder zusätzliche C-C-Doppel- oder C-C-Dreifachbindungen aktiviert sind. Genannt seien beispielsweise Vinylether und Vinylester, mit 3 bis 10, vorzugsweise 4 bis 8 Kohlenstoffatomen, Vinylaromaten, wie Styrol, Vinyltoluol, Acrylsäure und Methacrylsäure sowie deren Ester mit ein- oder mehrwertigen Alkoholen mit bis zu 20, vorzugsweise 1 bis 8 Kohlenstoffatomen, wie z.B. Methylmethacrylat, 2-Hydroxyethylacrylat, 2-Hydroxyethylmethacrylat, Butan-1,4-dioldiacrylat, Hexan-1,6-dioldiacrylat, Nitrile oder Amide der Acrylsäure bzw. Methacrylsäure, Malein- und Fumarester von Alkoholen mit 1 bis 20, vorzugsweise 1 bis 8 Kohlenstoffatomen, wie z.B. Fumarsäurediethylester sowie N-Vinylverbindungen, wie N-Vinylpyrrolidon, N-Vinylcaprolactam, N-Vinylcarbazol und Allylester wie Diallylphthalat.

Als photopolymerisierbare höhermolekulare Verbindungen sind beispielsweise geeignet: ungesättigte Polyester, hergestellt aus $\alpha,\beta$-ungesättigten Dicarbonsäuren, wie Maleinsäure, Fumarsäure oder Itaconsäure, gegebenenfalls im Gemisch mit gesättigten bzw. aromatischen Dicarbonsäuren wie Adipinsäure, Phthalsäure oder Terephthalsäure, durch Umsetzung mit Alkandiolen wie Ethylenglykol, Propylenglykol, Butandiol, Neopentylglykol oder oxalkyliertem Bisphenol A; Epoxidacrylate, hergestellt aus Acryl- oder Methacrylsäure und aromatischen oder aliphatischen Diglycidethern und Urethanacrylate (z.B. hergestellt aus Hydroxyalkylacrylaten und Polyisocyanaten) sowie Polyesteracrylate (z.B. hergestellt aus hydroxylgruppenhaltigen gesättigten Polyestern und Acryl- oder Methacrylsäure).

Den photopolymerisierbaren Verbindungen, deren Zusammensetzung für den jeweiligen Verwendungszweck dem Fachmann geläufig ist, können in bekannter Weise gesättigte und/oder ungesättigte Polymere sowie weitere Zusatzstoffe wie Inhibitoren gegen die thermische Polymerisation, Paraffin, Pigmente, Farbstoffe, Peroxide, Verlaufshilfsmittel, Füllstoffe und Glasfasern sowie Stabilisatoren gegen thermischen oder photochemischen Abbau zugesetzt sein.

Solche Gemische sind dem Fachmann bekannt. Art und Menge der Zusätze hängen vom jeweiligen Verwendungszweck ab. Die erfindungsgemässen Acylphosphinoxidverbindungen werden dabei im allgemeinen in einer Konzentration von 0,01 bis 15 Gew.-%, vorzugsweise 0,05 bis 5 Gew.-%, bezogen auf die photopolymerisierbare Masse, eingesetzt. Sie können gegebenenfalls mit Beschleunigern kombiniert werden, die den hemmenden Einfluss des Luftsauerstoffs auf die Photopolymerisation beseitigen.

Solche Beschleuniger bzw. Synergisten sind beispielsweise sekundäre und/oder tertiäre Amine, wie Methyldiethanolamin, Dimethylethanolamin, Triethylamin, Triethanolamin, p-Dimethylaminobenzoesäureethylester, Benzyldimethylamin, Dimethylaminoethylacrylat, N-Phenylglycin, N-Methyl-N-phenylglycin und analoge, dem Fachmann bekannte Verbindungen. Zur Beschleunigung der Aushärtung können weiterhin aliphatische und aromatische Halogenide dienen wie 2-Chlormethylnaphthalin, 1-Chlor-2-chlormethylnaphthalin sowie gegebenenfalls Radikalbildner, wie sie im allgemeinen als Initiatoren für die thermische Polymerisation eingesetzt werden, z.B. Peroxide, Azoverbindungen sowie C-C-labile Verbindungen, die in Mengen von bis zu 15 Gew.-%, bezogen auf die photopolymerisierbare Masse, zugesetzt werden können und dem Fachmann bekannt sind.

Ferner können die Acylphosphinoxidverbindungen, gegebenenfalls in Anwesenheit der oben bezeichneten Synergisten und Beschleuniger, bzw. in Kombination mit anderen Photoinitiatoren zur Lichthärtung von Überzügen, Lacken, Druckfarben oder für photosensible Aufzeichnungsmaterialien, wie z.B. photopolymerisierbare Druckplatten, und in styrolischen Polyesterharzen eingesetzt werden. Solche Photoinitiatoren sind z.B. aromatische Ketone wie Benzylketale, Benzoinether, Benzoinester, $C_1$- bis $C_3$-alkyl-, chlor- oder chlormethylsubstituierte Thioxanthone, die in der deutschen Patentanmeldung P Nr. 3020092.1 beschriebenen Acylphosphine sowie die aus DE-OS Nrn. 2830927 und 2909994 bekannten Acylphosphinoxide und Acylphosphinsäureester. Ferner zählen dazu aromatische Disulfide und Naphthalinsulfochloride sowie gegebenenfalls weitere, dem Fachmann bekannte, geeignete Verbindungen.

Als Strahlungsquellen für das die Polymerisation solcher Mischungen auslösende Licht verwendet man im allgemeinen solche, die Licht vorzugsweise im Absorptionsbereich der erfindungsgemässen Verbindungen aussenden, d.h. zwischen 230 und 450 nm. Besonders geeignet sind Quecksilber-Niederdruckstrahler, -Mitteldruck- und -Hochdruckstrahler sowie superaktinische Leuchtstoffröhren oder Impulsstrahler. Die genannten Lampen können gegebenenfalls dotiert sein.

Ein besonderer Vorteil der erfindungsgemässen Acylphosphinoxide ist, dass sie sich als Photoinitiatoren eignen, mit denen die Photopolymerisation mit längerwelligeren und damit ungefährlicheren Lichtquellen, wie Leuchtstoffröhren, bzw. die Härtung mit Sonnenlicht möglich ist.

Die in den nachstehenden Beispielen genannten Teile und Prozente beziehen sich, soweit nicht anders angegeben, auf das Gewicht. Volumenteile verhalten sich zu Teilen wie Liter zu Kilogramm.

Beispiel der erfindungsgemässen Verbindungen sind – ohne dies als Beschränkung zu sehen – in Tabelle 1 angeführt.

Zum Vergleich werden die in Tabelle 2 zusammengestellten Verbindungen aus DE-OS Nr. 2909994 herangezogen.

*Tabelle 1:*
*Erfindungsgemässe Acylphosphinoxid-Verbindungen*

| | | Schmp. (°C) | | Analyse (%) C | H | P |
|---|---|---|---|---|---|---|
| 1 | 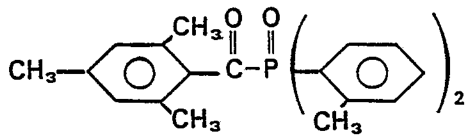 | 155-159 | ber.:<br>gef.: | 76,6<br>75,3 | 6,65<br>6,8 | 8,24<br>7,95 |
| 2 | 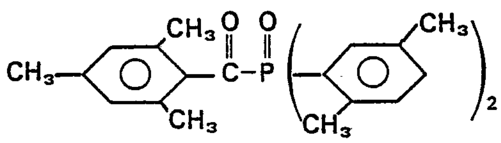 | 137-139 | ber.:<br>gef.: | 77,23<br>77,0 | 7,18<br>7,2 | 7,67<br>7,3 |
| 3 | 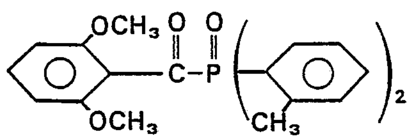 | 173-177 | ber.:<br>gef.: | 70,05<br>68,8 | 5,84<br>5,8 | 7,87<br>7,6 |
| 4 | 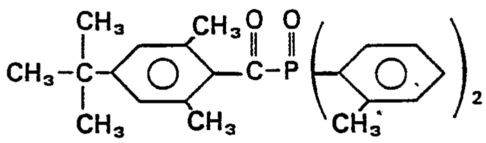 | 116-120 | ber.:<br>gef.: | 77,51<br>77,5 | 7,42<br>7,3 | 7,42<br>7,3 |
| 5 | 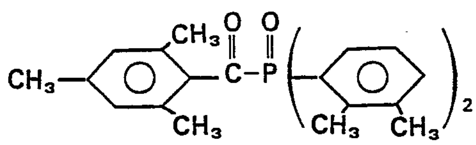 | 168-170 | ber.:<br>gef.: | 77,23<br>77,0 | 7,18<br>7,0 | 7,67<br>7,4 |

*Tabelle 2:*
*Zum Vergleich herangezogene Verbindungen nach DE-OS Nr. 2909994*

| | | Schmp. (°C) | Sdp. (°C/mm) | | Analyse (%) C | H | P |
|---|---|---|---|---|---|---|---|
| I | 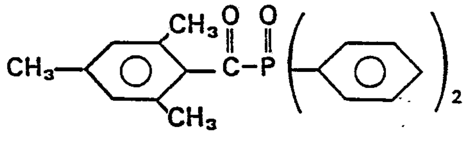 | 94 | — | ber.:<br>gef.: | 75,86<br>75,6 | 6,03<br>6,1 | 8,91<br>8,9 |
| II | 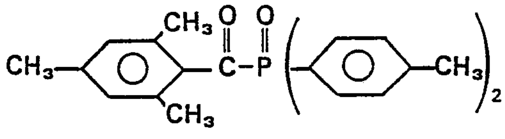 | 93-108 | — | ber.:<br>gef.: | 76,58<br>76,4 | 6,69<br>6,7 | 8,22<br>8,1 |
| III | 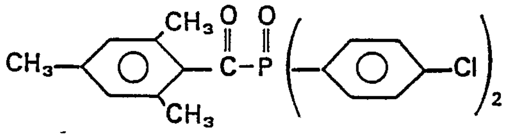 | 135-136 | — | ber.:<br>gef.: | 63,32<br>63,0 | 4,59<br>4,6 | 7,42<br>7,2 |

| | | Schmp. (°C) | Sdp. (°C/mm) | | Analyse (%) C | H | P |
|---|---|---|---|---|---|---|---|
| IV | 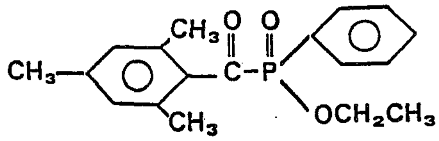 | 22-24 | 150-153°C/ 0,01 mm | ber.:<br>gef.: | 68,35<br>68,1 | 6,65<br>6,6 | 9,81<br>10,5 |
| V | 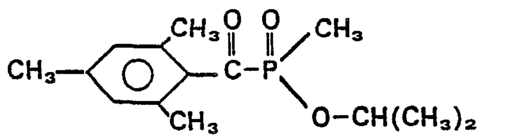 | <20 | 114°C/ 0,1 mm | ber.:<br>gef.: | 62,68<br>62,5 | 7,84<br>7,8 | 11,57<br>11,2 |

*Beispiel 1:*

*Herstellung eines Acylphosphinoxids:*

Zu 91,5 Gew.-Teilen 2,4,6-Trimethylbenzoesäurechlorid in 100 Volumenteilen Dioxan wurden bei Rückflusstemperatur innerhalb von 2 h 122 Teile Bis(o-tolyl)methoxyphosphin zugetropft. Anschliessend wurde 5 h lang unter Rückfluss nachgerührt, auf Raumtemperatur abgekühlt, abfiltriert und aus Toluol umkristallisiert.

Ausbeute 116,0 Teile (62% d.Th.)

Smp. 155 bis 159°C

*Analyse:*

| | | | |
|---|---|---|---|
| Berechnet: | C 76,6 | H 6,65 | P 8,24% |
| Gefunden: | C 75,3 | H 6,8 | P 7,95% |

*Beispiel 2:*

Durch Veresterung von 143 Teilen Tetrahydrophthalsäureanhydrid und 175 Teilen Maleinsäureanhydrid mit 260 Teilen Diethylenglykol wird zunächst ein ungesättigtes Polyesterharz erhalten, aus dem nach Zugabe von 0,01% Hydrochinon eine 64%ige Lösung in Styrol hergestellt wird.

Für die UV-Härtungsversuche werden zu 100 Teilen dieser Lösung 20 Teile Styrol, 30 Teile Titandioxid (RN 57) und 1,5 Teile Photoinitiator zugegeben und der Lack mit einem Filmziehgerät (Spaltbreite 100 µm) auf eine Glasplatte aufgezogen.

Nach etwa 1minütigem Ablüfen werden die Filme 20 s mit Quecksilberhochdrucklampen bestrahlt (30 W/cm Bogenlänge, Philips HTQ 7), die im Abstand von 15 cm über dem Objekt angeordnet sind.

Die Durchhärtung wurde durch Messung der Pendeldämpfung nach König (DIN 53147) bestimmt. Die Ergebnisse sind in Tabelle 3 zusammengestellt.

In einer 2. Versuchsreihe wurde die oben beschriebene Lösung mit einem Filmziehgerät in dikkerer Schicht (Spaltbreite 400 µm) auf Glasplatten aufgezogen und wie zuvor beschrieben bestrahlt.

Nach der Aushärtung wurden die Filme abgezogen, mit Aceton gewaschen und die Dicke der ausgehärteten Filme bestimmt. Dieses Mass für die aushärtbare Schichtdicke ist ebenfalls in Tabelle 3 aufgeführt.

Wie die Tabelle zeigt, übertreffen die Verbindungen 1 und 4 in ihrer Härtungswirkung für pigmentierte Polyesterlacke deutlich die Vergleichsverbindungen I und IV.

*Tabelle 3*

*UV-Härtung von pigmentierten ungesättigten Polyesterharzen*

| Initiator | Pendeldämpfung nach König (s) | durchhärtbare Schichtdicke (µm) |
|---|---|---|
| 1 | 72 | 170 |
| 4 | 70 | 160 |
| I | 63 | 100 |
| IV | 26 | 80 |

*Beispiel 3:*

Jeweils 1,5 Teile der zu vergleichenden Photoinitiatoren wurden in einer Mischung aus 56 Teilen eines Umsetzungsproduktes von Bisphenol-A-diglycidylether und Acrylsäure, 44 Teilen Hexandioldiacrylat, 30 Teilen Titandioxid (Rutil) und 3 Teilen Methyldiethanolamin gelöst.

Der Lack wird mit einem Filmziehgerät (Spaltbreite 100 µm) auf Glasplatten aufgezogen und mit einer Bandgeschwindigkeit von 5 m/min unter einer Quecksilberhochdrucklampe (100 W/cm Bogenlänge, Original Hanau Q 67 19), die im Abstand von 10 cm über dem Band angeordnet ist, gehärtet.

Die Durchhärtung wurde durch Messung der Pendeldämpfung nach König (DIN 53 147) bestimmt. Die Ergebnisse sind in Tabelle 4 zusammengestellt.

In einer 2. Versuchsreihe wurden die oben beschriebenen Lacke mit einem Filmziehgerät (400 µm) auf Glasplatten aufgezogen und wie zuvor beschrieben, jedoch bei einer Bandgeschwindigkeit von 10 m/min, gehärtet.

Nach der Aushärtung wurden die Filme abgezogen, mit Aceton gewaschen und die Dicke der ausgehärteten Filme bestimmt. Dieses Mass für die aushärtbare Schichtdicke ist ebenfalls in Tabelle 4 aufgeführt.

*Tabelle 4*

| Initiator | Pendeldämpfung (s) | härtbare Schichtdicke (μm) |
|---|---|---|
| 1 | 60 | 160 |
| 2 | 59 | 160 |
| I | 55 | 100 |
| II | 55 | 90 |
| III | 56 | 90 |
| IV | 53 | 70 |
| V | Oberfläche runzelig | 20 |

Die Verbindungen 1 und 2 übertreffen die zum Vergleich herangezogenen Verbindungen I bis V bei der härtbaren Schicht pigmentierter Lacke um 50 bis 100%.

*Beispiel 4:*

Zur Messung der Härtungsaktivität wurde der Temperaturverlauf im ungesättigten Polyesterharz (UP-Harz) während der UV-Belichtung aufgezeichnet; dazu tauchte ein mit einer Wachsschicht überzogener Thermofühler, der mit einem Temperaturschreiber (®Tastotherm Script 3 N, Standardfühler T 300 der Deutschen Gulton GmbH) verbunden war, in einen mit 10 g UP-Harz gefüllten Weissblechdeckel mit einem Durchmesser von 5 cm (Schichtdicke des UP-Harzes 4,8 mm). Zur Vermeidung von Wärmeverlusten während der UV-Belichtung war der Deckel in Polyurethanhartschaum eingebettet. Als Strahlungsquelle diente ein UV-Feld aus 5 Leuchtstoffröhren (TLAK 40 W/05, Philips) nebeneinander. Der Abstand Strahler/UP-Harzoberfläche betrug 8,5 cm.

Aus den registrierten Temperatur-Zeitkurven wurden als charakteristische Kenngrössen für die Härtungsaktivität die Härtungszeit $HZ_{25°C-T_{max}}$ und die maximal erreichte Härtungstemperatur $T_{max}$ entnommen. Als Härtungszeit gilt die Zeitspanne, in der die Probentemperatur von 25° C auf $T_{max}$ ansteigt.

Das Polyesterharz, mit dem die Beispiele und Vergleichsbeispiele durchgeführt wurden, ist eine mit 0,01% Hydrochinon stabilisierte, 65%ige styrolische Lösung eines ungesättigten Polyesters aus Maleinsäure, o-Phthalsäure, Ethylenglykol und Propylenglykol-1,2 im Molverhältnis 1:2:2,3:0,70. Der ungesättigte Polyester hat eine Säurezahl von 50.

*Tabelle 5*

*Härtungsaktivität verschiedener Verbindungen*

| Verbindung | Härtungsaktivität | |
|---|---|---|
| | $HZ_{25°C-T_{max}}$ | $T_{max}$(°C) |
| I | 4 min 45 s | 125 |
| II | 4 min 38 s | 101 |
| III | 4 min 53 s | 103 |
| IV | 7 min 08 s | 112 |
| V | 8 min 30 s | 103 |
| 1 | 4 min 23 s | 122 |
| 2 | 5 min 00 s | 121 |
| 3 | 5 min 38 s | 108 |

*Beispiel 5:*

In einem Bindemittel aus 65 Teilen eines Umsetzungsproduktes aus Bisphenol-A-glycidether und Acrylsäure, 35 Teilen Hexan-1,6-dioldiacrylat werden 3 Teile Photoinitiator gelöst. Die fertige Mischung wird auf Glasplatten in einer Schicht von 60 μm Dicke aufgerackelt und in 10 cm Abstand unter einer Quecksilberhochdrucklampe (Leistung 80 W/cm Bogenlänge) vorbeigeführt. Die Reaktivität ist als die maximal mögliche Transportbandgeschwindigkeit angegeben, bei der noch eine nagelharte kratzfeste Aushärtung des Überzuges erzielt wird. Die Ergebnisse sind in Tabelle 6 zusammengestellt.

*Beispiel 6:*

Zu einem nach Beispiel 4 hergestellten Lack werden 3% Methyldiethanolamin gegeben. Anschliessend wird wie in Beispiel 4 auf Glasplatten aufgezogen und belichet. Die Ergebnisse sind in Tabelle 6 zusammengefasst. Danach lässt sich die Härtungsgeschwindigkeit der erfindungsgemässen Verbindungen durch Zusatz eines Aminbeschleunigers erhöhen.

*Tabelle 6*

| Photoinitiator | maximale Transportbandgeschwindigkeit in m/min | | |
|---|---|---|---|
| | unter Luft | unter Intertgas | unter Luft, bei Zusatz von 3% Methyldiethanolamin |
| 1 | 12 | 150 | 53 |
| 2 | 15 | 150 | 55 |
| 3 | 15 | 140 | 53 |

## Patentansprüche

1. Acylphosphinoxide der allgemeinen Formel (I)

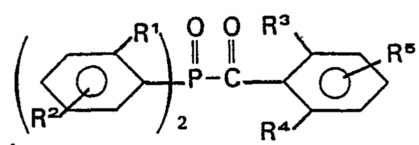

(I)

wobei

$R^1$ für eine Methyl- oder Ethylgruppe,

$R^2$ für eine verzweigte oder unverzweigte Alkylgruppe mit 1 bis 4 Kohlenstoffatomen, ein Chloratom, eine Alkoxygruppe mit 1 bis 4 Kohlenstoffatomen oder ein Wasserstoffatom stehen,

$R^3$ und $R^4$ untereinander gleich oder verschieden sind und für eine Alkyl-, Alkoxy- oder Alkylthiogruppe mit 1 bis 4 Kohlenstoffatomen oder ein Chloratom, und

$R^5$ für ein Wasserstoffatom, ein Chloratom, eine Alkoxy- oder Alkylthiogruppe mit 1 bis 6 Kohlenstoffatomen oder eine verzweigte oder unverzweigte Alkylgruppe mit 1 bis 12 Kohlenstoffatomen stehen.

2. Acylphosphinverbindungen nach Anspruch 1, dadurch gekennzeichnet, dass der durch $R^1$ und $R^2$ substituierte Phenylrest ein 2-Methylphenyl- oder ein 2,5-Dimethylphenylrest ist.

3. Acylphosphinverbindungen nach Anspruch 1, dadurch gekennzeichnet, dass der durch $R^3$, $R^4$ und $R^5$ substituierte Phenylrest ein 2,6-Dimethylphenyl-, 2,4,6-Trimethylphenyl-, 2,3,6-Trimethylphenyl-, 2,6-Dimethoxyphenyl-, 2,6-Dichlorphenyl-, 2,6-Bis(methylthio)phenyl-, ein 2,6-Dimethyl-4-tert.-butylphenyl- oder ein 2,6-Dimethyl-4-octylphenylrest ist.

4. Verwendung der Acylphosphinverbindungen nach den Ansprüchen 1 bis 3 als Photoinitiatoren in photopolymerisierbaren Massen.

5. Verwendung der Acylphosphinverbindungen nach Anspruch 4, in Kombination mit sekundären oder tertiären Aminen.

6. Verwendung der Acylphosphinverbindungen nach den Ansprüchen 1 bis 3 als Photoinitiatoren in photopolymerisierbaren Überzugsmitteln, Lacken, Druckfarben und Aufzeichnungsmaterialien, wobei diese den Photoinitiator in einer Konzentration von 0,01 bis 15 Gew.-% enthalten.

7. Verwendung nach einem der Ansprüche 4 oder 5, zur Herstellung von Kunststoffmassen auf Basis ungesättigter Polyesterharze, die gegebenenfalls weitere Hilfsstoffe, insbesondere Glasfasern und/oder Füllstoffe enthalten.

8. Verwendung nach den Ansprüchen 5 bis 7, dadurch gekennzeichnet, dass als Photoinitiatoren Acylphosphinverbindungen der allgemeinen Formel (I) in Kombination mit Verbindungen aus der Gruppe der Benzylketale, Benzoinether, Benzoinester, $C_1$- bis $C_4$-alkyl-, chlor- oder chlormethylsubstituierten Thioxanthone, aromatischen Disulfide, Naphthalinsulfochloride, Acylphosphine, Acylphosphinsäureester, Acylphosphinsulfide und andere, von den Acylphosphinoxiden gemäss Anspruch 1 verschiedene Acylphosphinoxide, eingesetzt werden.

9. Verwendung der Acylphosphinverbindungen nach den Ansprüchen 5 bis 8, in Kombination mit Initiatoren für die thermische Polymerisation.

## Claims

1. An acylphosphine oxide of the general Formula (I):

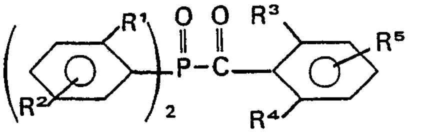

(I)

where:

$R^1$ is methyl or ethyl;

$R^2$ is a branched or straight-chain alkyl radical of 1 to 4 carbon atoms, chlorine, alkoxy of 1 to 4 carbon atoms or hydrogen;

$R^3$ and $R^4$ are identical or different and are each alkyl, alkoxy or alkylthio, each of 1 to 4 carbon atoms, or chlorine, and

$R^5$ is hydrogen, chlorine, alkoxy or alkylthio, each of 1 to 6 carbon atoms, or a branched or straight-chain alkyl radical of 1 to 12 carbon atoms.

2. An acylphosphine compound as claimed in Claim 1, wherein the phenyl radical susbtituted by $R^1$ and $R^2$ is 2-methylphenyl or 2,5-dimethylphenyl.

3. An acylphosphine compound as claimed in Claim 1, wherein the phenyl radical substituted by $R^3$, $R^4$ and $R^5$ is 2,6-dimethylphenyl, 2,4,6-trimethylphenyl, 2,3,6-trimethylphenyl, 2,6-dimethoxyphenyl, 2,6-dichlorophenyl, 2,6-bis-(methylthio)phenyl, 2,6-dimethyl-4-tert.-butylphenyl or 2,6-dimethyl-4-octylphenyl.

4. The use of an acylphosphine compound as claimed in Claims 1 to 3, as a photo-initiator in photopolymerizable compositions.

5. The use of an acylphosphine compound as claimed in Claim 4, in combination with a secondary or tertiary amine.

6. The use of an acylphosphine compound as claimed in Claims 1 to 3, as a photo-initiator in photopolymerizable coating materials, paints, printing inks and recording materials, the photo-initiator being present therein in a concentration of from 0.01 to 15% by weight.

7. The use as claimed in Claim 4 or 5, for the production of plastic materials based on unsaturated polyester resins which may contain further assistants, in particular glass fibers and/or fillers.

8. The use as claimed in Claims 5 to 7, wherein the photo-initiator used is an acylphosphine compound of the general Formula (I), in combination with a compound from the group comprising benzyl ketals, benzoin ethers, benzoin esters, $C_1$-$C_4$-alkyl-, chloro- or chloromethyl-substituted thioxanthones, aromatic disulfides, naphthalenesulfonyl chlorides, acylphosphines, acylphosphinic acid esters, acylphosphine sulfides, and acylphosphine oxides which differ from those claimed in Claim 1.

9. The use of an acylphosphine compound as claimed in Claims 5 to 8, in combination with a thermal polymerization initiator.

## Revendications

1. Oxydes d'acylphosphines de formule générale (I):

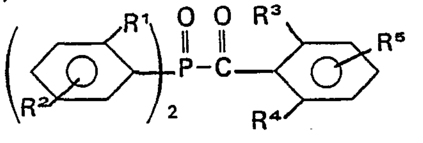

(I)

dans laquelle:

$R^1$ représente un groupe méthyle ou éthyle;

$R^2$ représente un groupe alkyle, ramifié ou non, ayant 1 à 4 atomes de carbone, un atome de chlore, un groupe alcoxy ayant 1 à 4 atomes de carbone ou un atome d'hydrogène;

$R^3$ et $R^4$ sont identiques ou différents et représentent un groupe alkyle, alcoxy ou alkylthio ayant 1 à 4 atomes de carbone ou un atome de chlore, et

$R^5$ représente un atome d'hydrogène, un atome de chlore, un groupe alcoxy ou alkylthio ayant 1 à 6 atomes de carbone, ou un groupe alkyle, ramifié ou non, ayant 1 à 12 atomes de carbone.

2. Dérivés d'acylphosphines selon la revendication 1, caractérisés par le fait que le reste phényle substitué par $R^1$ et $R^2$ est un reste 2-méthylphényle ou 2,5-diméthylphényle.

3. Dérivés d'acylphosphines selon la revendication 1, caractérisés par le fait que le reste phényle substitué par $R^3$, $R^4$ et $R^5$ est un reste 2,6-diméthylphényle, 2,4,6-triméthylphényle, 2,3,6-triméthylphényle, 2,6-diméthoxyphényle, 2,6-dichlorophényle, 2,6-bis(méthylthio)phényle, 2,6-diméthyl-4-tert.-butylphényle ou 2,6-diméthyl-4-octylphényle.

4. Utilisation des dérivés d'acylphosphines selon les revendications 1 à 3, comme photo-initiateurs en masses photopolymérisables.

5. Utilisation des dérivés d'acylphosphines selon la revendication 4, en combinaison avec des amines secondaires ou tertiaires.

6. Utilisation des dérivés d'acylphosphines selon les revendications 1 à 3, comme photo-initiateurs en revêtements, vernis, peintures, encres d'impression et matières d'enregistrement photopolymérisables, ceux-ci contenant les photo-initiateurs en une concentration de 0,01 à 15% en poids.

7. Utilisation selon l'une des revendications 4 ou 5, pour la préparation de masses de matières plastiques à base de résines polyester insaturées, qui contiennent éventuellement d'autres auxiliaires, en particulier des fibres de verre et/ou des charges.

8. Utilisation selon les revendications 5 à 7, caractérisée par le fait qu'on emploie, comme photo-initiateurs, des dérivés d'acylphosphines de formule générale (I), en combinaison avec des composés du groupe des benzylcétals, benzoïn-éthers, benzoïnesters, thioxanthones substituées par alkyle en $C_1$ à $C_4$, chlore ou chlorométhyle, disulfures aromatiques, sulfochlorures de naphtalène, acylphosphines, esters d'acide acylphosphinique, sulfures d'acylphosphine et autres oxydes d'acylphosphine différents des oxydes d'acylphosphine selon la revendication 1.

9. Utilisation des dérivés d'acylphosphines selon les revendications 5 à 8, en combinaison avec des initiateurs pour la polymérisation thermique.